# EUROPÄISCHE PATENTANMELDUNG

(11) **EP 2 883 982 A1**
(43) Veröffentlichungstag der Anmeldung: **17.06.2015**
(21) Anmeldenummer: 14004158.3
(22) Anmeldetag: 10.12.2014
(51) Int. Cl.: C23G 1/08, B21B 45/06, C23G 3/02, G05D 5/02, G01N 21/956, G01B 7/06

(54) **Vorrichtung und Verfahren zur Detektion des Fortschritts eines Abtragungsprozesses an der Oberfläche eines kaltgewalzten und/oder warmgewalzten Stahles**

(30) Priorität: 10.12.2013 DE 102013021041
(71) Anmelder: VDEh-Betriebsforschungsinstitut GmbH, 40237 Düsseldorf (DE)
(72) Erfinder: Wunde, Martin, 44869 Bochum (DE); Rögener, Frank, 40477 Düsseldorf (DE); Gröpper, Bernd-Alexander, 48317 Drensteinfurt (DE)
(74) Vertreter: Tilmann, Max Wilhelm

(57) **Zusammenfassung**

Vorrichtung zur Detektion eines Fortschritt eines Abtragungsprozess an der Oberfläche eines kaltgewalzten und/oder warmgewalzten Stahles mit einem Magnetometer und einer mit dem Magnetometer funktionell gekoppelten Auswerteeinheit, wobei die Auswerteeinheit derart ausgestaltet ist, den mit dem Magnetometer ermittelten Wert mit einem Schwellenwert zu vergleichen, der ein Maß für den Fortschritt des Abtragungsprozess ist.

## Beschreibung

Die Erfindung betrifft eine Vorrichtung, ein System und ein Verfahren zur Detektion des Fortschritts eines Abtragungsprozess an der Oberfläche eines kaltgewalzten und/oder warmgewalzten Stahles.

An korrosionsbeständige Stähle werden Anforderungen hinsichtlich der Korrosionsbeständigkeit gestellt. Eine metallisch saubere Oberfläche ist eine Voraussetzung für eine gute Korrosionsbeständigkeit. Die beim Erwärmen auf Walztemperatur des Stahles entstehende Zunderschicht ist daher nachteilig. Zudem diffundiert beim Erwärmen auf Walztemperatur Chrom aus tieferen Schichten an die Metalloberfläche bzw. in die Zunderschicht. Durch die Diffusion von Chrom kommt es unterhalb der Zunderschicht zur Ausbildung einer chromverarmten Schicht. Die chromverarmte Schicht weist eine geringe Korrosionsbeständigkeit auf. Es gibt daher das Bestreben, die Zunderschicht zusammen mit der chromverarmten Schicht vollständig zu entfernen, um die Korrosionsbeständigkeit der Stahloberfläche sicherzustellen. Der warmgewalzte Stahl kann gebeizt werden, wobei die Zunderschicht und die darunterliegende chromverarmte Schicht entfernt werden. Es können Bäder aus Fluß-, Salpeter-, Schwefel- und/oder auch Salzsäure Anwendung finden.

Es ist bekannt, mittels optischer Verfahren eine optische Kontrolle des Stahles durchzuführen. Mit einer optischen Kontrolle ist es allerdings nur möglich, die Zunderschicht zu erkennen, d.h. zu ermitteln, ob die Zunderschicht beispielsweise durch Beizen abgetragen wurde. Rückschlüsse auf ein Vorhandensein einer chromverarmten Schicht sind hieraus nicht möglich.

Aufgabe der Erfindung ist es daher, ein verbessertes Verfahren zu schaffen, das mit einfachen Mitteln eine Detektion des Fortschritts eines Abtragungsprozesses an der Oberfläche eines kaltgewalzten und/oder warmgewalzten Stahls erlaubt.

Die Aufgabe wird mit den Gegenständen der unabhängigen Patentansprüche 1, 4, 7 und 11 gelöst. Vorteilhafte Ausführungsformen sind in den Unteransprüchen und der hiernach folgenden Beschreibung wiedergegeben.

Kerngedanke der Erfindung ist die Ausnutzung des Unterschieds der Permeabilität der Zunderschicht, der Schicht und des Stahles. Die Erfinder haben erkannt, dass die Permeabilität der Zunderschicht, der chromverarmten Schicht und des Grundwerkstoff des Stahls (des Teil des Werkstoffs unterhalb der Zunderschicht und der chromverarmten Schicht) unterschiedlich sein kann und eine Aussage über Fortschritt eines Abtragungsprozess an der Oberfläche des kaltgewalzten und/oder warmgewalzten Stahles somit zulassen kann. Sofern an der Oberfläche des kaltgewalzten und/oder warmgewalzten Stahles eine Zunderschicht und/oder eine chromverarmte Schicht vorhanden sind, so kann dies erfindungsgemäß über die Detektion der Permeabilität an der Oberfläche bestimmt werden.

Insbesondere bevorzugt finden die erfindungsgemäße Vorrichtung, das erfindungsgemäße System und das erfindungsgemäße Verfahren Einsatz bei Abtragungsporzesses an Stählen, die eine chromverarmte Schicht mit ferritischen Anteilen und eine Grundwerkstoff mit austenitischem Gefüge aufweist. Im Vergleich zu Austeniten sind Ferrite magnetisierbar.

Die erfindungsgemäße Vorrichtung zur Detektion des Fortschritts eines Abtragungsprozess an der Oberfläche eines kaltgewalzten und/oder warmgewalzten Stahles weist ein Magnetometer und eine mit dem Magnetometer funktionell gekoppelte Auswerteeinheit auf. Die Auswerteeinheit ist dazu ausgestaltet, den mit dem Magnetometer ermittelten Wert mit einem vorbestimmten Schwellenwert zu vergleichen, der ein Maß für den Fortschritt des Abtragungsprozess ist.

In einer bevorzugten Ausführungsform weist die Vorrichtung einen Abstandssensor auf.

Das erfindungsgemäße Verfahren, die erfindungsgemäße Vorrichtung und das erfindungsgemäße System sind einfach durchführbar bzw. aufgebaut. So kann der Fortschritt des Abtragungsprozess beispielsweise berührungslos detektiert werden.

Der Begriff Magnetometer umfasst erfindungsgemäß eine sensorische Vorrichtung zur Messung magnetischer Flussdichten. Insbesondere wird von dem Begriff Magnetometer eine Förster-Sonde, ein Saturationskern-Magnetometer, ein Kerr-Magnetometer, ein optisch gepumptes Magnetometer, ein SQUID, ein Protonenmagnetometer, ein Magnetometer auf Basis von Bose-Einsteln-Kondensaten, ein XMR-Sensor, ein Hall-Sensor, eine Feldplatte umfasst. Das Magnetometer ist zur Messung des magnetischen Flusses an der Oberfläche des Stahls ausgestaltet. Es wird Insbesondere bevorzugt das Vorhandensein von Zunder und/oder das Vorhandensein der chromverarmten Schicht in Abhängigkeit von der Größe des gemessenen magnetischen Flusses ermittelt.

Der Schwellenwert kann beispielsweise dadurch ermittelt werden, dass in einem Testlauf für eine bestimmte Stahlsorte die Schichtdicke der chromverarmten Schicht mit ferritischen Anteilen mit anderen Messmitteln, beispielsweise mit Gammaspektroskopie, Eletronenspektroskople (Photoelektronenspektroskopie mit Röntgenstrahlen-XPS, Photoelektronenspektroskopie mit UV-Licht-UPS, Winkelaufgelöste Photoelektronenspektroskopie-ARPES, Auger-Eletronen-Spektroskopie-AES, Eletronen-Energieverlustspektroskopie-EELS), Röntgenspektroskopie-XRS (Röntgenfluoreszenzanalyse-RFA, Röntgenbeugungsspektroskopie, Röntgenabsorptionsspektroskopie-XAS), Glimmentladungsspektroskopie (GDOES), Rasterelektronenmikroskopischen Untersuchungen an der Oberfläche oder im Querschnitt oder metallografische Untersuchungen am Querschliff ermittelt und zugleich einem Vorhandensein oder der Schichtdicke der chromverarmten Schicht mit ferritischen Anteilen zugehörige Messwert des Magnetometers festgehalten wird. Dieses Vorgehen kann für weitere Schichtdicken wiederholt werden, so dass nach Durchführung des Testlaufs eine Tabelle entsteht, die Messwerten des Magnetometers tatsächlich gemessene Schichtdicken der chromverarmten Schicht mit ferritischen Anteilen zuordnet. Wird nun ein Stahl dieser Stahlsorte, an dem ein Abtragungsprozess an der Oberfläche durchgeführt wird, der erfindungsgemäßen Vorrichtung zugeführt, so kann die Auswerteeinheit aus dem Messwert des Magnetometers und der Tabelle die Schichtdicke der chromverarmten Schicht mit ferritischen Anteilen feststellen und damit der Fortschritt des Abtragungsprozess an der Oberfläche. Mit weiteren Testläufen können weitere Schwellwerte für andere Stahlsorten aber auch für anders konditionierte Stähle der gleichen Stahlsorte ermittelt werden, beispielsweise für solche, die neben der chromverarmten Schicht mit ferritischen Anteilen noch eine Zunderschicht aufweisen.

Ebenso Ist eine Ausführungsform denkbar, bei der in einem Testlauf für einen Stahl einer bestimmte Stahlsorte, der eine gewünschte Schichtdicke der chromverarmten Schicht mit ferritischen Anteilen und/oder der Zunderschicht aufweist, der zugehörige Messwert des Magnetometers als Schwellwert festgehalten wird. Wird nun ein Stahl dieser Stahlsorte, an dem ein Abtragungsprozess an der Oberfläche durchgeführt wird, der erfindungsgemäßen Vorrichtung zugeführt, so kann die Auswerteeinheit aus dem Messwert des Magnetometers im Vergleich mit dem Schwellwert feststellen, ob der Stahl bereits die gewünschte Schichtdicke der chromverarmten Schicht mit ferritischen Anteilen erreicht hat.

In einer bevorzugten Ausführungsform werden dem gewünschten Fortschreiten des Abtragungsprozesses entsprechend mehrere Schwellenwert in Testläufen ermittelt, nämlich jeweils ein Schwellwert für eine gewünschte Schichtdicke der chromverarmten Schicht mit ferritischen Anteilen und/oder der Zunderschicht. Bei dieser Ausführungsform wird je nach Anforderung an den Fortschritt des Abtragungsprozesses, also je nachdem welche Schichtdicke für den gerade erreichten Zustand des Abtragungsprozess gerade gewünscht wird, ein Schwellwert in der Auswerteeinheit zum Vergleich mit dem Messwert des Magnetometers bereitgestellt. Der Schwellenwert ist somit in Abhängigkeit von der Anforderung an den Fortschritt des Abtragungsprozess veränderbar.

Das erfindungsgemäße System wird aus mindestens einem Beizbad und einer erfindungsgemäßen Vorrichtung gebildet. Das Beizbad kann dabei nach chemischem oder elektrochemischem Prinzip arbeiten. Bei diesem System kann ein kaltgewalzter und/oder warmgewalzter Stahl durch das Beizbad geführt werden und das Magnetometer den kaltgewalzten und/oder warmgewalzter Stahl zumindest an einer Stelle außerhalb des Beizbads untersuchen. Es hat sich gezeigt, dass mit der erfindungsgemäßen Vorrichtung besonders gut der Fortschritt eines Beizprozesses an der Oberfläche eines kaltgewalzten und/oder warmgewalzten Stahles feststellen lässt.

In einer bevorzugten Ausführungsform ist die Auswerteeinheit mit einer Steuereinheit gekoppelt, die Einfluss auf die Verweilzeit des Stahles Im Belzbad nehmen kann. Wird durch die erfindungsgemäße Vorrichtung festgestellt, dass der Fortschritts des Beizprozesses nicht dem gewünschten Fortschritt zu dem jeweiligen Zeitraum entspricht, so kann durch Einstellen der Verwellzeit des Stahls Im Beizbad erreicht werden, dass zukünftig der gewünschte Fortschritt des Beizprozess erreicht wird. Wird mittels des erfindungsgemäßen Systems beispielsweise ein Stahlband gebeizt und ist die erfindungsgemäße Vorrichtung am Ende des Beizbads angeordnet, so kann mittels des Systems der Fortschritt des Beizprozesses an dem Bandabschnitt festgestellt werden, der gerade das Beizbad verlässt. Wird festgestellt, dass an diesem Bandabschnitt der Fortschritts des Beizprozesses nicht dem gewünschten Fortschritt zu dem jeweiligen Zeitraum entspricht, so kann durch Einstellen der Verweilzeit des Stahlbands im Beizbad zumindest erreicht werden, dass für die weiteren, noch im Beizbad befindlichen Bandabschnitte der gewünschte Fortschritt des Beizprosses erreicht wird.

In einer bevorzugten Ausführungsform ist das Magnetometer in funktionelle Anlagenbestandteile am Auslauf des Beizbades integriert. Als funktionelle Anlagenbestandteile werden solche verstanden, die bei der Behandlung des Stahls eine Funktion übernehmen, wie beispielsweise das Fördern des Stahls oder das Abquetschen von Beizflüssigkeit von dem Stahl.

Bei dem erfindungsgemäßen Verfahren zur Detektion des Fortschritts eines Abtragungsprozess an der Oberfläche eines kaltgewalzten und/oder warmgewalzten Stahles wird ein magnetischer Fluss an der Oberfläche des Stahls gemessen und das Vorhandensein von Zunder und/oder einer chromverarmten Schicht In Abhängigkeit von der Größe des gemessenen magnetischen Flusses ermittelt.

In einer bevorzugten Ausführungsform wird der magnetische Fluss mittels eines Magnetometers gemessen.

In einer bevorzugten Ausführungsform wird der kaltgewalzte und/oder warmgewalzte Stahl vor der Messung des magnetischen Flusses durch ein Beizbad geführt.

In einer bevorzugten Ausführungsform wird die Verweilzeit des Stahles im Beizbad in Abhängigkeit von dem gemessenen magnetischen Fluss gesteuert oder geregelt.

In einer bevorzugten Ausführungsform wird die Messung des magnetischen Fluss an der Oberfläche des Stahls zwischen zwei Beizbecken durchgeführt wird.

Vorrichtung, System und Verfahren sind onlinefähig. Es kann beispielsweise der Beizprozess des kaltgewalzten und/oder warmgewalzten Stahls hinsichtlich Beizgenauigkeit näher an die Grenze Grundstoff (austenitischer Stahl) / chromverarmte Schicht herangeführt werden.

Die Erfindung betrifft auch die Verwendung eines Magnetometers und einer Auswerteeinheit zur Detektion und Regelung des Beizfortschrittes eines kaltgewalzten und/oder warmgewalzten Stahles.

In einer bevorzugten Ausführungsform ist der Abtragungsprozess ein chemisches Abtragen, beispielsweise ein Ätzen oder Verbrennen, oder ein elektrochemisches Abtragen, beispielsweise ein elektroerodieren, elektrochemisches Abtragen oder Metallätzen.

Das erfindungsgemäße Verfahren, die erfindungsgemäße Vorrichtung und das erfindungsgemäße System finden auch beim Beizen Anwendung, bei dem das Beizmittel auf eine Oberfläche aufgetragen wird, beispielsweise mittels eines Pinsels. Derartige Beizverfahren finden beispielsweise beim Zusammenschweißen von Rohren oder Tanks, insbesondere auch im Reaktorbau Anwendung. So wird nach dem Schweißen von austenitischen Edelstählen die chromverarmte Schicht erneut abgetragen.

Die Erfindung wird nachfolgend anhand eines von in der Zeichnung dargestellten Ausführungsbeispiels näher erläutert.

In der Zeichnung zeigt:

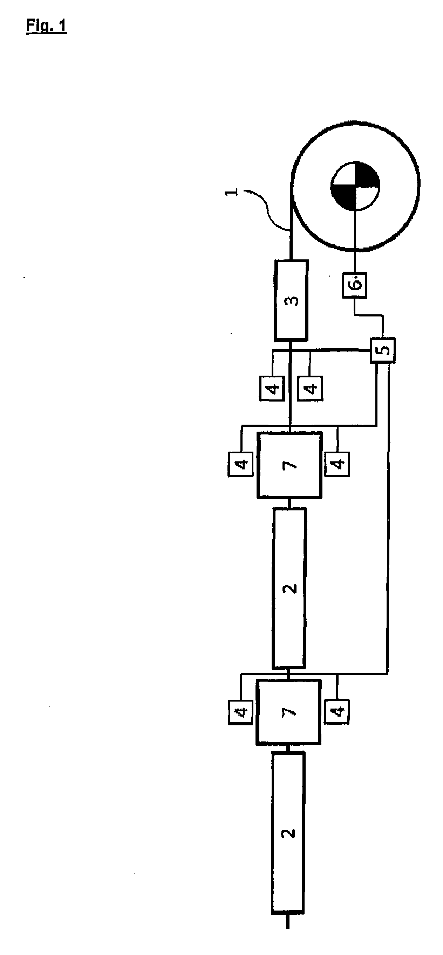

- Fig. 1: eine schematische Ansicht einer erfindungsgemäßen Vorrichtung bei einem Beizprozess eines kaltgewalzten und/oder warmgewalzten Stahles.

Die Fig. 1 zeigt schematisch einen Beizprozess eines kaltgewalzten und/oder warmgewalzten Stahlbands 1 in einer Beize eines Beizbades 2 und einer anschließenden Spüle in einem Spülbad 3. Am Auslaufbereich der Beiz- und Spülbäder befinden sich funktionelle Anlagenbestandteile, wie Abquetschrollen 7. Im Bereich der Oberfläche des Stahlbands 1 ist ein Magnetometer 4 angeordnet, mit dem die Permeabilität des Stahlbands 1 ermittelbar Ist. Das Magnetometer 4 Ist mit einer Auswerteeinheit 5 funktionell gekoppelt und kann den von dem Magnetometer 4 ermittelten Permeabilitätswert mit einem Schwellwert vergleichen. Wird der Schwellwert unterschritten, so liegt keine Zunderschicht und auch keine chromverarmte Schicht mehr vor.

Schematisch ist in der Fig. auch eine Steuervorrichtung 6 eingezeichnet, mit der in Abhängigkeit von der ermittelten Permeabilität Einfluss auf die Zelt genommen werden kann, die das Stahlband 1 Im Beizbad 2 gebeizt wird. Hierdurch kann der Beizprozess hinsichtlich der Beizgenauigkeit näher an die Grenze Grundwerkstoff/chromverarmte Schicht herangeführt werden. Die Auswerteeinheit 5 kann mittels dem Vergleich mit dem Schwellwert entscheiden, ob die Beizzeit, mit der durch die Steuereinheit 6 Einfluss genommen werden kann, vergrößert oder verringert werden soll. In der Fig. ist schematisch dies dadurch gezeigt, dass die Geschwindigkeit des Stahlbands 1 vergrößert bzw. verringert werden kann.

Der Schwellwert, der verwendet wird, um zu entscheiden, ob eine Zunderschicht und/oder eine chromverarmte Schicht vorliegen, ist deswegen insbesondere programmierbar bzw. veränderbar, da die Permeabilität beispielsweise durch verformungsinduziertem Martensit, magnetische Phasen im Austenitgefüge und/oder Zundereindrücke beeinflusst werden kann. Beispielsweise kann der Schwellwert aufgrund von metallografischen Untersuchungen des betrachteten Stahles eingestellt werden.

## Patentansprüche

1. Vorrichtung zur Detektion eines Fortschritt eines Abtragungsprozess an der Oberfläche eines kaltgewalzten und/oder warmgewalzten Stahles (1) mit einem Magnetometer (4) und einer mit dem Magnetometer funktionell gekoppelten Auswerteeinheit (5), wobei die Auswerteeinheit (5) derart ausgestaltet ist, den mit dem Magnetometer (4) ermittelten Wert mit einem Schwellenwert zu vergleichen, der ein Maß für den Fortschritt des Abtragungsprozess ist.

2. Vorrichtung nach Anspruch 1, wobei der Schwellenwert in Abhängigkeit von der Anforderung an den Fortschritt des Abtragungsprozess veränderbar ist.

3. Vorrichtung nach Anspruch 1 oder 2, wobei das Magnetometer (4) eine Förster-Sonde ist.

4. System aus einem Beizbad (2) und einer Vorrichtung nach einem der Ansprüche 1 bis 3, bei dem ein kaltgewalzter und/oder warmgewalzter Stahl (1) durch das Beizbad (2) geführt werden kann und das Magnetometer (4) den kaltgewalzten und/oder warmgewalzten Stahl (1) zumindest an einer Stelle außerhalb des Beizbads untersuchen kann.

5. System nach Anspruch 4, wobei die Auswerteeinheit (5) mit einer Steuereinheit (6) gekoppelt ist, die Einfluss auf die Verweilzeit des Stahles (1) im Beizbad (2) nehmen kann.

6. System nach Anspruch 4 oder 5, **dadurch gekennzeichnet, dass** das Magnetometer (4) in funktionelle Anlagenbestandteile (7) am Auslauf des Beizbades (2) integriert Ist.

7. Verfahren zur Detektion des Fortschritts eines Abtragungsprozess an der Oberfläche eines kaltgewalzten und/oder warmgewalzten Stahles (1), wobei ein magnetischer Fluss an der Oberfläche des Stahls gemessen wird und das Vorhandensein von Zunder und/oder einer chromverarmten Schicht in Abhängigkeit von der Größe des gemessenen magnetischen Flusses ermittelt wird.

8. Verfahren nach Anspruch 7, wobei der magnetische Fluss mittels eines Magnetometers gemessen wird.

9. Verfahren nach Anspruch 7 oder 8, **dadurch gekennzeichnet, dass** der kaltgewalzte und/oder warmgewalzten Stahl (1) vor der Messung des magnetischen Flusses durch ein Belzbad (2) geführt wird.

10. Verfahren nach Anspruch 9, **dadurch gekennzeichnet, dass** die Verweilzeit des Stahles (1) im Beizbad (2) in Abhängigkeit von dem gemessenen magnetischen Fluss gesteuert oder geregelt wird.

11. Verfahren nach einem der Ansprüche 7 bis 10, **dadurch gekennzeichnet, dass** die Messung des magnetischen Fluss an der Oberfläche des Stahls zwischen zwei Beizbecken (2) durchgeführt wird.

12. Verwendung eines Magnetometers (4) und einer mit dem Magnetometer funktionell verbundenen Auswerteeinheit (5) zur Detektion des Fortschritts eines Abtragungsprozess an der Oberfläche eines kaltgewalzten und/oder warmgewalzten Stahles.
